# EUROPÄISCHE PATENTANMELDUNG

(11) **EP 3 840 068 A1**
(43) Veröffentlichungstag der Anmeldung: **23.06.2021**
(21) Anmeldenummer: 19217282.3
(22) Anmeldetag: 18.12.2019
(51) Int. Cl.: H01L 33/50

(54) **WEISSES LICHT ABSTRAHLENDES LED-MODUL**

(71) Anmelder: Zumtobel Lighting GmbH, 6850 Dornbirn (AT)
(72) Erfinder: MARTIN, Kenneth, 6923 Lauterach (AT); OSL, Lukas, 6900 Bregenz (AT)
(74) Vertreter: Zumtobel Group IP Management

(57) **Zusammenfassung**

Die vorliegende Erfindung betrifft ein LED-Modul (100), aufweisend: einen LED-Chip (102), welcher ausgebildet ist, eine elektromagnetische Strahlung zu emittieren, zumindest einen Leuchtstoff (104), welcher dazu geeignet ist, die Strahlung des LED-Chips (102) in ein Licht umzuwandeln, wobei ein Emissionsspektrum des LED-Modules (100) einen blauen Lichtanteil und einen grünen Lichtanteil enthält, wobei eine Intensität des blauen Lichtanteils größer als eine CIE-Intensität gleicher Farbtemperatur ist und wobei eine Intensität des grünen Lichtanteils kleiner als eine CIE-Intensität gleicher Farbtemperatur ist.

## Beschreibung

### 1. Gebiet der Erfindung

Die vorliegende Erfindung betrifft ein LED-Modul zum Erzeugen eines Emissionsspektrums, insbesondere ein mischfarbiges Licht oder weißes Licht emittierendes LED-Modul oder LED-Leuchte.

### 2. Hintergrund

Aus dem Stand der Technik sind LEDs bekannt, deren Emissionsspektrum einem Zielkompromiss folgend zusammengesetzt ist. Dieser Kompromiss besteht darin, die maximale Lichtausbeute bei einer definierten minimalen Farbwiedergabestufe, z.B. >80, >90 oder sogar >97, zu erreichen.

Die per Definition für alle denkbaren Testobjekte maximal hohe Farbwiedergabe würde ein Emissionsspektrum aufweisen, welches dem Referenzlichtspektrum bei der gleichen korrelierten Farbtemperatur und dem gleichem Lichtstrom entspricht.

Hierbei wird als Referenzlichtspektrum gemäß der CIE Empfehlung ein Plancksches Emissionsspektrum bei korrelierten Farbtemperaturen (CCTs = Correlated color temperature) von kleiner als 5000 K, oder aber bei größeren CCTs ein CIE Standard Tageslichtspektrum der gleichen CCT verwendet.

Im IES TM-30-15 Standard wurde die gleiche Methodik verwendet und die Trennung ebenfalls bei 5000 K vollzogen. Dies wurde jedoch in der 2018 aktualisierten Version TM-30-18 geändert, hier ist eine Trennung bei 4000 K festgelegt (darüber Tageslichtspektren, darunter Plancksche Emissionsspektren).

Für eine maximale Lichtausbeute werden Bereiche des Emissionsspektrums, welche für die Farbtreue der beleuchteten (beim CRI 8 definierte Pastellton) Testfarben weniger wichtig sind, bei der Emission ausgespart. Mit dieser Herangehensweise werden Emissionsspektren auf Ziel-Farbwiedergaben und maximale Effizienz optimiert. Die dabei entstehenden Emissionsspektren, werden in der Regel erzeugt, indem die abgegebene Farbe aus einer Blau-Komponente bei ca. 450 nm mit weiteren Farbkomponenten längerer Wellenlängen gemischt werden.

Die besagte Blau-Komponente emittiert hauptsächlich in dem Wellenlängenbereich, bei dem die kurzwellig empfindlichen Blau-Rezeptoren des menschlichen Auges etwa ihre Maximalempfindlichkeit aufweisen und wird somit in der Regel durch blau emittierende LED-Chips, die bei etwa 450 nm Wellenlänge auf maximale Wirkungsgrade optimiert wurden, erzeugt. Durch ein Teil dieses Lichts der LED-Chips werden zudem in der Regel ein oder mehrere Leuchtstoffe zur Emission von Farben größerer Wellenlängen von Cyan bis Rot angeregt.

Die Dichte der Leuchtstoffe im Licht-Weg vor der kurzwellig emittierenden LED wird stofflich derart eingestellt, dass nur ein definierter Anteil an kurzwelligem, blauem Licht und ein definierter Anteil an den anderen Farben gesamthaft oder zumindest in eine bestimmte Richtung emittiert wird und somit ein Lichtspektrum erzeugt wird, welches dem Ziel-Farbtemperatur-Referenzlichtspektrum relativ nahe kommt.

Dabei wird jedoch typischerweise ein für nichtvisuelle Wirkungen auf den Menschen wichtiger Azurblau-Anteil ausgespart, da dieser mit aktuellen Leuchtstoffen nicht höchsteffizient durch blaues Licht angeregt erzeugt werden kann und der zudem als Gegenpol für die richtige Zielfarbtemperatur und den richtigen weißen Zielfarbort einen stärkeren Orange-Rotanteil bräuchte, der jedoch den Lichtstrom-Wirkungsgrad (den Wert des photometrischen Strahlungs-Äquivalents des Emissionsspektrums) und damit in der Folge auch die Lichtausbeute reduzieren würde.

Zudem sind künstliche Lichtspektren, die im Vergleich zu Lichtspektren natürlicher Lichtquellen deutliche Intensitätsabweichungen in Form von Spitzen (Peaks) aufweisen, kritisch zu betrachten, da durch die Lage der Peaks zufällig bei individuell unterschiedlichen Zellen-Empfindlichkeiten sehr unterschiedliche und ggf. bislang unerforschte visuelle oder nichtvisuelle Auswirkungen durch die einzelnen Zellen bzw. Individuen (Menschen) haben könnten.

Ziel ist es deshalb, natürlichen Lichtquellen entsprechend, ein möglichst kontinuierliches Lichtspektrum künstlich zu erzeugen. Der Azurblau-Anteil wird nun bei neuartigen Lösungen mit der direkten Emission von LED-Chips bei ca. 465-485 nm erhöht, was jedoch eine zusätzliche Komplexitätsstufe darstellt und die LED-Module damit teurer macht. Zudem wird eine weitere kritisch zu betrachtende Spitze im Emissionsspektrum erzeugt.

Als Alternative werden Lösungen mit sehr kurzwelligem Chipemissionen bei 400-415 nm und entsprechenden blauen Leuchtstoffen und langwelligen Leuchtstoffen erzeugt, die jedoch aufgrund der breiten Emission im violett-blauen Bereich entsprechend als Gegengewicht für den gewünschten Farbort ebenfalls wieder einen starken Rot-Anteil benötigen, der wie oben beschrieben die Lichtausbeute deutlich reduziert.

Durch den oben genannten Zielkompromiss zielt die Optimierung generell immer auf eine möglichst gute Anpassung an die Referenzlichtspektren bei der Zielfarbtemperatur ab.

Das Problem dabei ist, gute Anpassungen an die Referenzlichtspektren bei der Zielfarbtemperatur zu erreichen. Ferner ist das Problem dabei, dass das Licht, welches auf die Menschen am Tage einen natürlich aktivierenden Effekt hat, immer hohe Farbtemperaturen aufweist (ab 5000 K aufwärts bis 16000 K, gestreutes blaues Himmelslicht im Schatten), aus ästhetischen Gründen und Gewohnheiten in Innenräumen jedoch in der Regel meist wärmere Farbtemperaturen eingesetzt werden (bis zu 5000 K, selten höher).

Die kurzwelligen Anteile und vor allem die wichtigen Azurblau-Anteile des natürlichen Lichts sind also bei den in der Innenraumbeleuchtung verwendeten typischen Farbtemperaturen deutlich reduziert, wenn man wie bislang üblich den Vergleich bei gleichen lichttechnischen Werten macht (Lumen, Candela, Lux). Nach neueren Erkenntnissen hat der Azurblau-Anteil, welcher auch als melanopischer Anteil bezeichnet wird und zu dem es seit kurzem eine standardisierte Augenempfindlichkeitskurve gibt, eine wesentliche Wirkung auf den Pupillendurchmesser und auf die chemische Helligkeitsadaptation im Auge und somit auf visuelle Effekte wie Blendung, Kontrastsehen, Sehklarheit usw.

Durch diese außergewöhnliche Wirkung des melanopischen Anteils wird für die vorliegende Erfindung die Annahme getroffen, dass ein Vergleich von Emissionsspektren bei gleicher melanopischer Wirkung ("melanopische Beleuchtungsstärke" oder andere) gemacht werden sollte.

Im Lichte des beschriebenen Standes der Technik ist es eine Aufgabe der vorliegenden Erfindung, ein neuartiges Emissionsspektrum mit einer für Innenräume gewöhnlichen niedrigen Farbtemperatur, welches dem Tageslichtspektrum in weiten Bereichen des emissionsspektralen Verlaufs nahe kommt, bereitzustellen. Damit soll eine Verbesserung der LED Beleuchtung ermöglicht werden.

Diese und andere Aufgaben, die beim Lesen der folgenden Beschreibung noch genannt werden oder vom Fachmann erkannt werden können, werden durch den Gegenstand der unabhängigen Ansprüche gelöst. Die abhängigen Ansprüche bilden den zentralen Gedanken der vorliegenden Erfindung in besonders vorteilhafter Weise weiter.

### 3. Ausführliche Beschreibung der Erfindung

Gemäß einem ersten Aspekt betrifft die vorliegende Erfindung ein LED-Modul, wobei das LED-Modul aufweist: einen LED-Chip, welcher ausgebildet ist, eine Strahlung zu emittieren, zumindest einen Leuchtstoff, welcher dazu geeignet ist, die Strahlung des LED-Chips in ein Licht umzuwandeln, wobei ein Emissionsspektrum des LED-Modules einen blauen Lichtanteil und einen grünen Lichtanteil enthält, wobei eine Intensität des blauen Lichtanteils größer als eine CIE-Intensität gleicher Farbtemperatur ist und wobei eine Intensität des grünen Lichtanteils kleiner als eine CIE-Intensität gleicher Farbtemperatur ist.

Dieses Emissionsspektrum des LED-Moduls hat den Vorteil, dass es optimiert für visuelle und nicht visuelle Effekte ist.

Ferner ist dieses Emissionsspektrum des LED-Modules ähnlich dem Tageslichtspektrum. Somit enthält das emittierte Licht /Spektrum natürliche physiologische Eigenschaften. Vorzugsweise ist dieses Emissionsspektrum des LED-Modules in einem wichtigen Spektralbereich ähnlich dem Tageslichtspektrum mit höherer CCT.

Ferner hat das Emissionsspektrum eine positive Wirkung auf die Gesundheit des Menschen, ist insbesondere für Kinder geeignet und erfüllt die jetzigen Standards und Verordnungen.

Gemäß einer Ausführungsform ist der zumindest eine Leuchtstoff ausgebildet, die Strahlung des LED-Chips zumindest teilweise zu absorbieren und in Licht in einem anderen, insbesondere größeren, Wellenlängenbereich als die Strahlung zu emittieren, wobei das Emissionsspektrum des LED-Moduls durch eine Mischung der Strahlung des LED-Chips und des durch den Leuchtstoff emittierten Lichts erzeugt wird.

Dies hat den Vorteil, dass die durch den LED-Chip emittierte Strahlung, welche beispielsweise in einem blauen oder violetten Bereich liegen kann, in ein für das menschliche Auge geeignete(re)s Licht umgewandelt wird.

Gemäß einer Ausführungsform umfasst das LED-Modul eine Abdeckung, insbesondere einen Globe-Top, welche den zumindest einen Leuchtstoff enthält.

Der Globe-Top kann insbesondere mit dem wenigstens einen Leuchtstoff versetzt sein und in Abstrahlrichtung des LED-Chips angeordnet sein.

Gemäß einer Ausführungsform emittiert der LED-Chip die Strahlung in einem violetten Wellenlängenbereich, welcher insbesondere keinen UV Anteil aufweist.

Gemäß einer WHO-Definition wird unter UV (ultraviolett) dabei der Bereich von unterhalb von 400 nm angrenzend verstanden.

Gemäß einer Ausführungsform zeigt das Emissionsspektrum des LED-Moduls in einem Bereich von 460 nm bis 550 nm, insbesondere in einem blauen Bereich, keine nach oben ausreißende Spitze.

Das heißt in diesem Bereich gibt es bei keiner Wellenlänge eine plötzliche Erhöhung der Intensität. Die Intensität verändert sich über diesen Bereich nur moderat. Dies hat den Vorteil, dass die für den Menschen für individuelle menschlichen Empfindlichkeiten unvorteilhaft wirkenden Wellenlängen in dem Emissionsspektrum nicht dominant sein können, da ihre Intensität gering ist (keine Spitze(n)).

Gemäß einer Ausführungsform ist das Emissionsspektrum des LED-Moduls bei einer Farbtemperatur von 4000 K im Wesentlichen, vorzugsweise im wesentlich wichtigen Spektralbereich von 460-550nm, gleich einem normierten Tageslichtspektrum gemäß CIE einer höheren Farbtemperatur.

Dies hat den Vorteil, dass das durch das LED-Modul künstlich erzeugte Licht eine natürliche Wirkung auf den Menschen hat (ähnlich wie das Tageslicht).

Gemäß einer Ausführungsform ist die Farbtemperatur des normierten Tageslichtspektrums 5700 K.

Gemäß einer Ausführungsform liegt das Emissionsspektrum des LED-Moduls in einem grünen Bereich, beispielsweise von 530 nm bis 550 nm, bei einer Farbtemperatur von 4000 K bevorzugt nah an dem Tageslichtspektrum bei 5700 K.

Gemäß einer Ausführungsform liegt eine Intensität des Emissionsspektrums in diesem Wellenlängenbereich unterhalb einer Intensität des Tageslichtspektrums bei identischer Temperatur, beispielsweise 4000 K.

Gemäß einer Ausführungsform ist ein Farbwiedergabeindex CRI (Color Rendering Index) oder Ra des Spektrums des LED-Moduls über 90.

Gemäß einer Ausführungsform wird das Emissionsspektrum des LED-Moduls durch eine farbstoffkonvertierte LED enthaltend den LED-Chip und den wenigstens einen Leuchtstoff erzeugt.

Eine farbstoffkonvertierte LED umfasst also einen LED-Chip der elektromagnetische Strahlung emittiert und wenigstens einen Leuchtstoff der diese Strahlung zumindest teilweise in andere elektromagnetische Strahlung/Licht umwandelt.

Gemäß einer Ausführungsform wird das Emissionsspektrum des LED-Moduls durch Kombination einer farbstoffkonvertierte LED, enthaltend den LED-Chip und den wenigstens einen Leuchtstoff, und den optischen Eigenschaften einer Leuchte erzeugt.

Beispielweise reduzieren die optischen Eigenschaften der Leuchte den Violett-Anteil des LED-Chips bzw. der farbstoffkonvertierten LED.

Gemäß einer Ausführungsform ist eine Intensität der Strahlung des LED-Chips durch Amplituden- oder Pulsweiten-Modulation veränderbar.

Gemäß einer Ausführungsform ist die Wellenlänge der Strahlung des LED-Chips über einen Vorwärtsstrom oder über dessen Temperatur veränderbar.

Gemäß einer Ausführungsform liegt in einem Bereich von 410 nm bis 430 nm eine erste Emissionsspitze des Emissionsspektrums des LED-Moduls, welche eine geringere Intensität als eine zweite Emissionsspitze des Emissionsspektrums bei circa 460 nm hat.

Gemäß einer Ausführungsform liegt bei circa 605 nm eine dritte Emissionsspitze des Emissionsspektrums liegt, welche eine größere Intensität als die erste Emissionsspitze des Emissionsspektrums hat.

Gemäß einer Ausführungsform liegt bei circa 605 nm eine dritte Emissionsspitze des Emissionsspektrums, welche eine geringere oder eine größere Intensität als die zweite Emissionsspitze des Emissionsspektrums hat.

Gemäß einem zweiten Aspekt betrifft die vorliegende Erfindung ein Verfahren für ein LED-Modul, umfassend die folgenden Schritte: Emittieren einer Strahlung und Umwandeln (mittels wenigstens eines Leuchtstoffes) der Strahlung eines LED-Chips des LED-Moduls in ein Licht, wobei ein Emissionsspektrum des LED-Moduls einen blauen Lichtanteil und einen grünen Lichtanteil enthält, wobei eine Intensität des blauen Lichtanteils größer als eine CIE-Intensität gleicher Farbtemperatur ist und wobei eine Intensität des grünen Lichtanteils kleiner als eine CIE-Intensität gleicher Farbtemperatur ist.

### 4. Beschreibung bevorzugter Ausführungsformen

Nachfolgend wird eine detaillierte Beschreibung der Figuren gegeben. Darin zeigt:
- **Figur 1**: eine schematische Darstellung eines LED-Moduls gemäß einer Ausführungsform der Erfindung;
- **Figur 2**: verschiedene Emissionsspektren bei gleicher Farbtemperatur und deren Unterschied gemäß einer Ausführungsform der Erfindung;
- **Figur 3**: verschiedene Emissionsspektren bei gleicher Farbtemperatur und deren Unterschied gemäß einer Ausführungsform der Erfindung;
- **Figur 4**: verschiedene Emissionsspektren bei unterschiedlicher Farbtemperatur und deren Unterschied gemäß einer Ausführungsform der Erfindung;
- **Figur 5**: verschiedene Emissionsspektren bei unterschiedlicher Farbtemperatur und deren Unterschied gemäß einer Ausführungsform der Erfindung; und
- **Figur 6**: ein Verfahren für ein LED-Modul gemäß einer Ausführungsform der Erfindung.

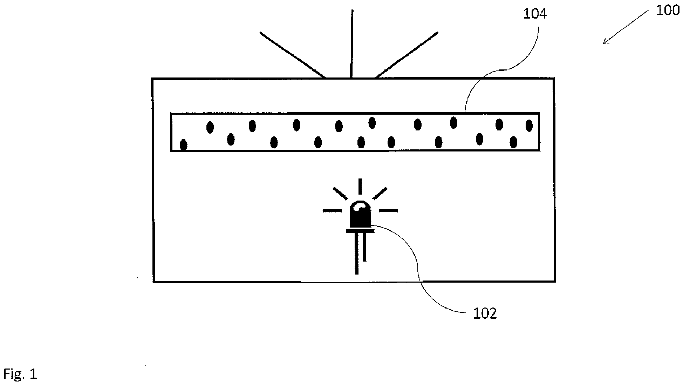

**Figur 1** zeigt eine schematische Darstellung eines LED-Moduls 100 gemäß einer Ausführungsform der Erfindung.

Das LED-Modul 100 umfasst einen LED-Chip 102, welcher dazu ausgebildet ist, eine Strahlung zu emittieren. Beispielweise kann diese Strahlung blaues oder violettes Licht umfassen. Vorzugsweise umfasst die Strahlung keine UV Strahlung. Ferner umfasst das LED-Module 100 zumindest einen Leuchtstoff 104, welcher dazu geeignet ist, die Strahlung des LED-Chips 102 in ein Licht, d.h. sichtbare Strahlung, umzuwandeln.

Ein Emissionsspektrum des LED-Moduls 100 enthält einen blauen Lichtanteil und einen grünen Lichtanteil, wobei eine Intensität des blauen Lichtanteils größer als eine CRI-Intensität gleicher Farbtemperatur ist und wobei eine Intensität des grünen Lichtanteils kleiner als eine CIE-Intensität gleicher Farbtemperatur ist. Das Emissionsspektrum des LED-Moduls 100 kann durch die Strahlung des LED-Chips 102 und das von dem wenigstens einen Leuchtstoff 104 abgegebene Licht erzeugt werden. Der Leuchtstoff 104 kann also die Strahlung des LED-Chips 102 teilweise umwandeln. Auch eine komplette Umwandlung der Strahlung des LED-Chips 102 in das Licht ist denkbar.

Das Emissionsspektrum des LED-Moduls 100 hat den Vorteil, dass im (potentiell für das Auge schädlicheren) kurzwelligen Bereich unterhalb von 460 nm eine niedrigere emissionsspektrale Intensität und im orange-roten Wellenlängenbereich eine höhere Intensität im Vergleich zu den natürlichen Emissionsspektren vorliegt, wobei die wichtigsten Bereiche im Vergleich der azurblauen bis limettengrünen Wellenlängenbereiche sind, die erfindungsgemäß nahe am natürlichen Emissionsspektrum liegen.

Ausführungsbeispiele der erfindungsgemäßen technischen Lösungen (Leuchte inklusiv Optik bzw. LED Modul 100 mit/ohne Optik) basieren beispielweise auf einem LED-Chip 102, welcher eine Chip-Emissionsspitze von 420-425nm (violett) aufweist, und wobei das Licht anteilig von einem Leuchtstoffgemisch oder Leuchtstoff 104 durch Fluoreszenzeffekte remittiert wird. Das LED-Modul 100 kann auch mehrere LED-Chips 102 enthalten und wenigstens elektromagnetische Strahlung von einem Led-Chip 102 bis hin zu allen LED-Chips 102 wird von dem wenigstens einen Leuchtstoff 104 umgewandelt.

Mittels einer Optik (bspw. Reflektor, Linsen, Diffusoren, transparente oder transluzente Materialien oder Kombinationen dergleichen) kann insbesondere ein Teil des violetten Lichts des LED-Chips 102 absorbiert werden, um das beschriebene Emissionsspektrum des LED-Moduls 100 zu erreichen.

Die mengenmäßige Zusammensetzung und die Verteilung des Leuchtstoffs 104 im Empfangsbereich des violetten Lichts des LED-Chips 102 kann derartig ausgebildet sein, dass insgesamt ein Lichtspektrum erzeugt wird, welches die folgenden Eigenschaften beim Vergleich mit natürlichen Lichtspektren (Planck bis 4800 K, darüber CIE Tageslichtspektren) auf der Basis gleicher melanopischer Wirkung aufweist: Bei einer CCT, die um 1250K bis 1750K niedriger als die des verglichenen natürlichen Lichts ist, beträgt die Abweichung zu diesem natürlichen Emissionsspektrum in der emissionsspektralen Intensität im Bereich von 460-550nm maximal ±15% bei einzelnen Wellenlängen.

Der Verlauf der verglichenen Emissionsspektren unterschiedlicher CCT ist hierbei bis auf mögliche leichte Welligkeiten nahezu parallel in diesem Wellenlängenbereich von 460-550nm. Durch den emissionsspektralen Verlauf wird eine Farbwiedergabestufe von CRI>=90 und ein R9 von ca. 50 oder leicht darüber erreicht. Außerdem übersteigt das photometrische Strahlungsäquivalent des Emissionsspektrums des LED-Moduls 100 bei 4000 K einen Wert von 290 lm/Wrad.

Vorteilweise auf diese Art und Weise wird eine Lichtquelle (LED-Modul 100) erzeugt, welche in der nicht-visuellen Wirkung und überraschenderweise auch der visuellen Wirkung des Tageslichts-Äquivalents höherer Farbtemperatur näher kommt.

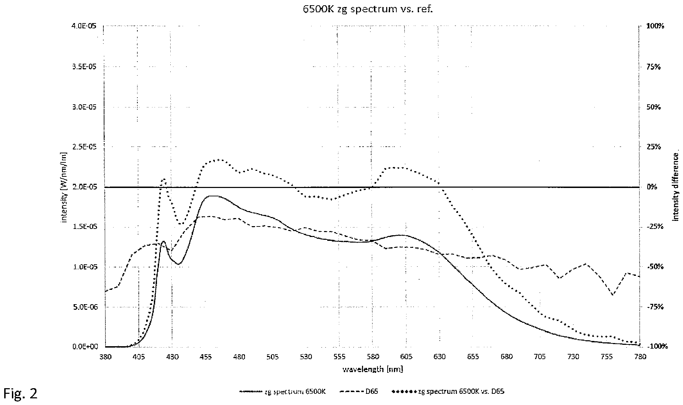

**Figur 2** zeigt verschiedene Emissionsspektren bei gleicher Farbtemperatur und deren Unterschied gemäß einer bevorzugten Ausführungsform der Erfindung.

Ein Ausführungsbeispiel für ein Emissionsspektrum eines erfindungsgemäßen LED-Moduls 100 ist in Fig. 2 dargestellt. In der Fig. 2 sind der Verlauf des Referenz-Emissionsspektrums der CIE ("D65") und das Emissionsspektrum ("zg spectrum") eines erfindungsgemäßen LED-Moduls 100 gemäß einem bevorzugten Ausführungsbeispiel dargestellt.

Das Referenz-Emissionsspektrum der CIE ist in der Fig. 2 beispielhaft anhand des Verlaufes D65 für eine Lichtfarbe von 6500 K erläutert. Anstelle des D65 Referenz-Emissionsspektrums der CIE kann die Erfindung auch für alle anderen Referenz-Emissionsspektren der CIE angewendet werden.

Das Emissionsspektrum eines erfindungsgemäßen LED-Moduls 100 gemäß dem Beispiel der Fig. 2 zeichnet sich dadurch aus, dass es nahezu keine Emission im Bereich unter einer Wellenlänge von 405 nm aufweist. Im Bereich von 420 bis 425 liegt eine erste Emissionsspitze, diese erste Emissionsspitze weist aber eine geringere Intensität als die zweite Emissionsspitze bei ca. 460 nm und die dritte und Emissionsspitze bei ca. 605 nm auf.

Vorzugsweise weist das Emissionsspektrum im Bereich zwischen der Emission bei circa 530 nm und der dritten Emissionsspitze bei ca. 605 nm nahezu eine gleich starke Emission annähernd dem Wert der Emission bei ca. 530 nm auf.

Gemäß einer besonders bevorzugten Variante liegt die Intensität des Emissionsspektrums des erfindungsgemäßen LED-Moduls 100 in dem Bereich von 450 nm bis 525 nm über dem Verlauf der D65 Referenz-Emissionsspektrum, also eine Intensitätsüberhöhung im Vergleich zum D65 Referenz-Emissionsspektrum in diesem Bereich vorliegt.

Gemäß einer besonders bevorzugten Variante liegt die Intensität des Emissionsspektrums des erfindungsgemäßen LED-Moduls 100 in dem Bereich von 525 nm bis 580 nm unterhalb des Verlaufs der D65 Referenz-Emissionsspektrum, also eine Intensitätsreduktion im Vergleich zum D65 Referenz-Emissionsspektrum in diesem Bereich vorliegt.

Gemäß einer besonders bevorzugten Variante liegt die Intensität des Emissionsspektrums des erfindungsgemäßen LED-Moduls 100 in dem Bereich von 580 nm bis 630 nm über dem Verlauf der D65 Referenz-Emissionsspektrum, also eine Intensitätsüberhöhung im Vergleich zum D65 Referenz-Emissionsspektrum in diesem Bereich vorliegt.

Gemäß einer besonders bevorzugten Variante liegt die Intensität des Emissionsspektrums des erfindungsgemäßen LED-Moduls 100 in dem Bereich von über 630 nm unterhalb dem Verlauf der D65 Referenz-Emissionsspektrum, also eine Intensitätsreduktion im Vergleich zum D65 Referenz-Emissionsspektrum in diesem Bereich vorliegt.

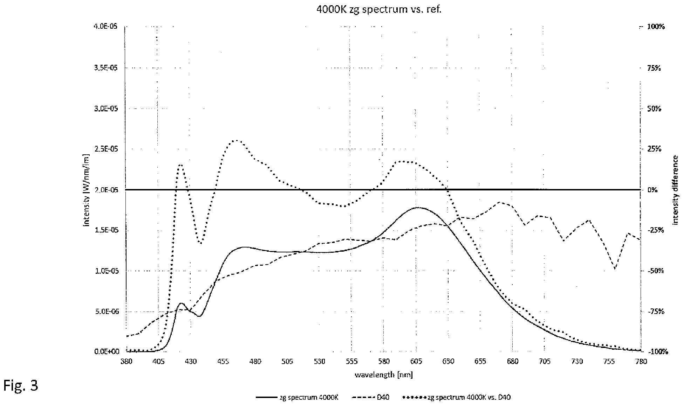

**Figur 3** zeigt verschiedene Emissionsspektren bei gleicher Farbtemperatur und deren Unterschied gemäß einer bevorzugten Ausführungsform der Erfindung;

Ein Ausführungsbeispiel für ein Emissionsspektrum eines erfindungsgemäßen LED-Moduls 100 ist in Fig. 3 dargestellt. In der Fig. 3 sind der Verlauf des Referenz-Emissionsspektrums der CIE ("D40") und das Emissionsspektrum ("zg spectrum") eines erfindungsgemäßen LED-Moduls 100 gemäß einem bevorzugten Ausführungsbeispiel dargestellt.

Das Referenz-Emissionsspektrum der CIE ist in der Fig. 3 beispielhaft anhand des Verlaufes D40 für eine Lichtfarbe von 4000 K erläutert. Anstelle des D40 Referenz-Emissionsspektrums der CIE kann die Erfindung auch für alle anderen Referenz-Emissionsspektren der CIE angewendet werden.

Das Emissionsspektrum eines erfindungsgemäßen LED-Moduls 100 gemäß dem Beispiel der Fig. 3 zeichnet sich dadurch aus, dass es nahezu keine Emission im Bereich unter einer Wellenlänge von 405 nm aufweist. Im Bereich von 420 bis 425 liegt eine erste Emissionsspitze, diese erste Emissionsspitze weist aber eine geringere Intensität als die zweite Emissionsspitze bei ca. 470 nm und die dritte und Emissionsspitze bei ca. 605 nm auf.

Vorzugsweise weist das Emissionsspektrum im Bereich zwischen der zweite Emissionsspitze bei ca. 470 nm und der Emission bei ca. 555 nm nahezu eine stabile Emission annähernd dem Wert der zweiten Emissionsspitze bei ca. 470 auf.

Gemäß einer besonders bevorzugten Variante liegt die Intensität des Emissionsspektrums des erfindungsgemäßen LED-Moduls 100 in dem Bereich von 450 nm bis 515 nm über dem Verlauf der D40 Referenz-Emissionsspektrum, also eine Intensitätsüberhöhung im Vergleich zum D40 Referenz-Emissionsspektrum in diesem Bereich vorliegt.

Gemäß einer besonders bevorzugten Variante liegt die Intensität des Emissionsspektrums des erfindungsgemäßen LED-Moduls 100 in dem Bereich von 515 nm bis 570 nm unterhalb des Verlaufs des D40 Referenz-Emissionsspektrums, also eine Intensitätsreduktion im Vergleich zum D40 Referenz-Emissionsspektrum in diesem Bereich vorliegt.

Gemäß einer besonders bevorzugten Variante liegt die Intensität des Emissionsspektrums des erfindungsgemäßen LED-Moduls 100 in dem Bereich von 570 nm bis 630 nm über dem Verlauf der D40 Referenz-Emissionsspektrum, also eine Intensitätsüberhöhung im Vergleich zum D40 Referenz-Emissionsspektrum in diesem Bereich vorliegt.

Gemäß einer besonders bevorzugten Variante die Intensität des Emissionsspektrums des erfindungsgemäßen LED-Moduls in dem Bereich von über 630 nm unterhalb dem Verlauf der D40 Referenz-Emissionsspektrum liegt, also eine Intensitätsreduktion im Vergleich zum D40 Referenz-Emissionsspektrum in diesem Bereich vorliegt.

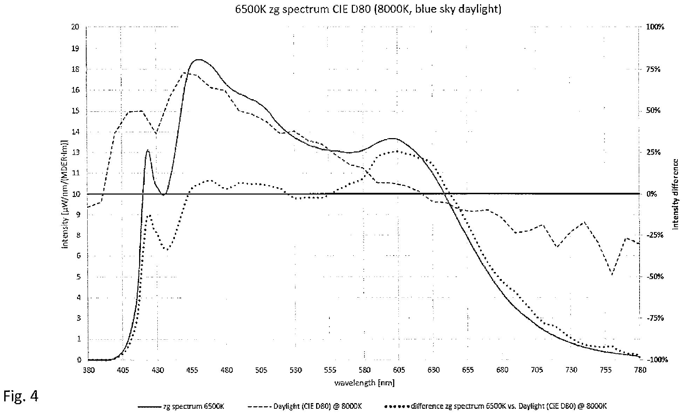

**Figur 4** zeigt verschiedene Emissionsspektren bei unterschiedlicher Farbtemperatur und deren Unterschied gemäß einer bevorzugten Ausführungsform der Erfindung.

Ein Ausführungsbeispiel für ein Emissionsspektrum eines erfindungsgemäßen LED-Moduls 100 ist in Fig. 4 dargestellt. In der Fig. 4 sind der Verlauf des Referenz-Emissionsspektrums der CIE ("D80") und das Emissionsspektrum ("zg spectrum") eines erfindungsgemäßen LED-Moduls 100 gemäß einem bevorzugten Ausführungsbeispiel dargestellt.

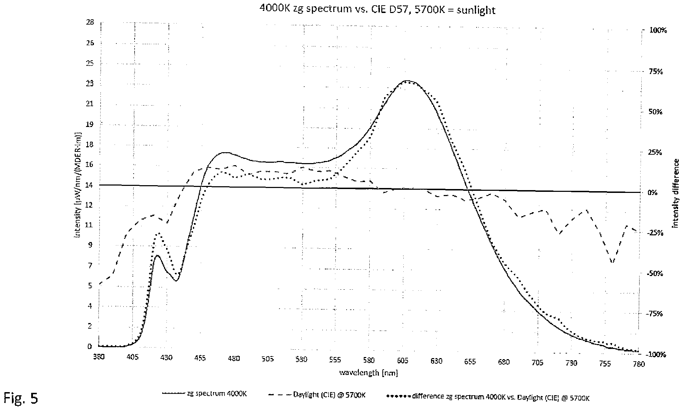

Das Referenz-Emissionsspektrum der CIE ist in der Fig. 5 beispielhaft anhand des Verlaufes D80 für eine Lichtfarbe von 8000 K erläutert. Anstelle des D80 Referenz-Emissionsspektrums der CIE kann die Erfindung auch für andere Referenz-Emissionsspektren der CIE im Bereich von 1250K bis 1750K höherer CCTs angewendet werden.

Das Emissionsspektrum eines erfindungsgemäßen LED-Moduls 100 gemäß dem Beispiel der Fig. 5 zeichnet sich dadurch aus, dass es nahezu keine Emission im Bereich unter einer Wellenlänge von 400 nm aufweist. Im Bereich von 420 bis 425 liegt eine erste Emissionsspitze, diese erste Emissionsspitze weist aber eine geringere Intensität als die zweite Emissionsspitze bei ca. 460 nm und die dritte und Emissionsspitze bei ca. 605 nm auf.

Im vorliegenden Vergleich der Emissionsspektren werden anstelle des Lichtstroms die melanopischen also nicht-visuellen Wirkungen der beiden Spektren als Vergleichsbasis herangezogen.

Gemäß einer besonders bevorzugten Variante liegt die Intensität des Emissionsspektrums des erfindungsgemäßen LED-Moduls 100 in dem Bereich von 380 nm bis 450 nm unter dem Verlauf der D80 Referenz-Emissionsspektrum, also eine Intensitätsreduktion im Vergleich zum D80 Referenz-Emissionsspektrum in diesem Bereich vorliegt.

Gemäß einer besonders bevorzugten Variante die Intensität des Emissionsspektrums des erfindungsgemäßen LED-Moduls in dem Bereich von 450 nm bis 525 nm über dem Verlauf der D80 Referenz-Emissionsspektrum liegt, also eine Intensitätsüberhöhung im Vergleich zum D80 Referenz-Emissionsspektrum in diesem Bereich vorliegt.

Gemäß einer besonders bevorzugten Variante liegt die Intensität des Emissionsspektrums des erfindungsgemäßen LED-Moduls 100 in dem Bereich von 525 nm bis 555 nm unterhalb des Verlaufs des D80 Referenz-Emissionsspektrums, also eine Intensitätsreduktion im Vergleich zum D80 Referenz-Emissionsspektrum in diesem Bereich vorliegt.

Gemäß einer besonders bevorzugten Variante liegt die Intensität des Emissionsspektrums des erfindungsgemäßen LED-Moduls 100 in dem Bereich von 555 nm bis 640 nm über dem Verlauf der D80 Referenz-Emissionsspektrum, also eine Intensitätsüberhöhung im Vergleich zum D80 Referenz-Emissionsspektrum in diesem Bereich vorliegt.

Gemäß einer besonders bevorzugten Variante liegt die Intensität des Emissionsspektrums des erfindungsgemäßen LED-Moduls in dem Bereich von über 640 nm unterhalb dem Verlauf der D80 Referenz-Emissionsspektrum liegt, also eine Intensitätsreduktion im Vergleich zum D80 Referenz-Emissionsspektrum in diesem Bereich vorliegt.

Eine bevorzugte Ausführungsform weist eine sehr kleine Abweichung (vorzugsweise innerhalb 15%) der beiden Spektren im Bereich 460nm bis 550nm auf, da dieser Bereich für die nicht-visuellen Wirkungen von besonderer Bedeutung ist.

**Figur 5** zeigt verschiedene Emissionsspektren bei unterschiedlicher Farbtemperatur und deren Unterschied gemäß einer bevorzugten Ausführungsform der Erfindung.

Ein Ausführungsbeispiel für ein Emissionsspektrum eines erfindungsgemäßen LED-Moduls 100 ist in Fig. 5 dargestellt. In der Fig. 5 sind der Verlauf des Referenz-Emissionsspektrums der CIE ("Daylight") und das Emissionsspektrum ("zg spectrum") eines erfindungsgemäßen LED-Moduls 100 gemäß einem bevorzugten Ausführungsbeispiel dargestellt.

Das Referenz-Emissionsspektrum der CIE ist in der Fig. 5 beispielhaft anhand des Verlaufes "Daylight" für eine Lichtfarbe von 5700 K erläutert. Anstelle des Referenz-Emissionsspektrums der CIE kann die Erfindung auch für alle anderen Referenz-Emissionsspektren der CIE angewendet werden.

Das Emissionsspektrum "zg spectrum" eines erfindungsgemäßen LED-Moduls 100 gemäß dem Beispiel der Fig. 5 zeichnet sich dadurch aus, dass es nahezu keine Emission im Bereich unter einer Wellenlänge von 405 nm aufweist. Im Bereich von 420 bis 425 liegt eine erste Emissionsspitze, diese erste Emissionsspitze weist aber eine geringere Intensität als die zweite Emissionsspitze bei ca. 470 nm und die dritte und Emissionsspitze bei ca. 605 nm auf.

Gemäß einer besonders bevorzugten Variante liegt die Intensität des Emissionsspektrums des erfindungsgemäßen LED-Moduls in dem Bereich von 380 nm bis 460 nm unterhalb des Verlaufs des Referenz-Emissionsspektrums, also eine Intensitätsreduktion im Vergleich zum Referenz-Emissionsspektrum in diesem Bereich vorliegt.

Vorzugsweise weist das Emissionsspektrum im Bereich zwischen der zweite Emissionsspitze bei ca. 470 nm und 555 nm nahezu eine stabile Emission annähernd dem Wert der ersten Emissionsspitze auf.

Gemäß einer besonders bevorzugten Variante liegt die Intensität des Emissionsspektrums des erfindungsgemäßen LED-Moduls 100 in dem Bereich von 460 nm bis 655 nm über dem Verlauf des Referenz-Emissionsspektrums, also eine Intensitätsüberhöhung im Vergleich zum Referenz-Emissionsspektrum in diesem Bereich vorliegt.

Gemäß einer besonders bevorzugten Variante liegt die Intensität des Emissionsspektrums des erfindungsgemäßen LED-Moduls 100 in dem Bereich von über 655 nm unterhalb dem Verlauf des Referenz-Emissionsspektrums, also eine Intensitätsreduktion im Vergleich zum Referenz-Emissionsspektrum in diesem Bereich vorliegt.

Eine bevorzugte Ausführungsform weist eine sehr kleine Abweichung (vorzugsweise innerhalb 15%) der beiden Spektren im Bereich 460nm bis 550nm auf, da dieser Bereich für die nicht-visuellen Wirkungen von besonderer Bedeutung ist.

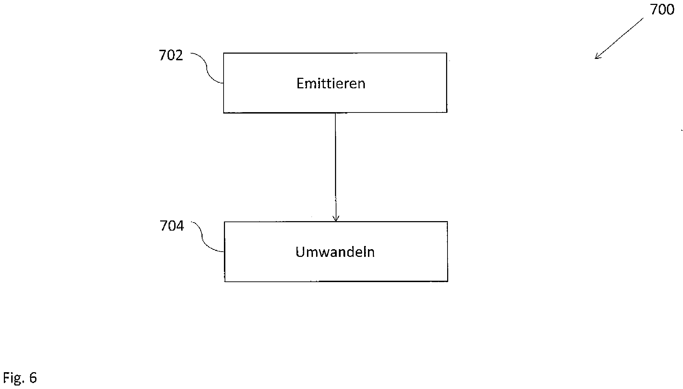

**Figur 6** zeigt ein Verfahren 700 für ein LED-Modul 100 gemäß einer bevorzugten Ausführungsform der Erfindung.

Das Verfahren 700 für ein LED-Modul 100 umfasst die folgenden Schritte:
- Emittieren 702 einer Strahlung (durch einen LED-Chip 102);
- Umwandeln 704 der Strahlung des LED-Chips 102 in ein Licht (durch wenigstens einen Leuchtstoff), wobei ein Emissionsspektrum des LED-Moduls 100 einen blauen Lichtanteil und einen grünen Lichtanteil enthält, wobei eine Intensität des blauen Lichtanteils größer als eine CIE-Intensität gleicher Farbtemperatur ist und wobei eine Intensität des grünen Lichtanteils kleiner als eine CIE-Intensität gleicher Farbtemperatur ist.

Einerseits kann dieses Emissionsspektrum des LED-Moduls 100 direkt durch einen farbstoffkonvertierte LED-Chip 102 erzeugt werden.

Andererseits kann das gewünschte Emissionsspektrum nicht nur das Resultat eines farbstoffkonvertierten LED-Chips 102 selbst, sondern das Resultat des Zusammenspiels dieser Lichtquelle (LED-Chip 102 und Leuchtstoff(e)) mit den optischen Eigenschaften einer Leuchte, die beispielsweise den Violett-Anteil der Primäranregung reduzieren kann.

## Patentansprüche

1. LED-Modul (100), aufweisend:
- zumindest einen LED-Chip (102), welcher ausgebildet ist, eine elektromagnetische Strahlung zu emittieren;
- zumindest einen Leuchtstoff (104), welcher dazu geeignet ist, die Strahlung des LED-Chips (102) in ein Licht umzuwandeln, wobei
- ein Emissionsspektrum des LED-Modules (100) einen blauen Lichtanteil und einen grünen Lichtanteil enthält, wobei
- eine Intensität des blauen Lichtanteils größer als eine CIE-Intensität gleicher Farbtemperatur ist und wobei
- eine Intensität des grünen Lichtanteils kleiner als eine CIE-Intensität gleicher Farbtemperatur ist.

2. LED-Modul (100) nach Anspruch 1,
wobei der zumindest eine Leuchtstoff (104) ausgebildet ist, die elektromagnetische Strahlung des LED-Chips (102) zumindest teilweise zu absorbieren und in Licht in einem anderen, insbesondere größeren, Wellenlängenbereich als die elektromagnetische Strahlung zu emittieren, wobei das Emissionsspektrum des LED-Moduls (100) durch eine Mischung der Strahlung des LED-Chips (102) und des durch den Leuchtstoff (104) emittierten Lichts erzeugt wird.

3. LED-Modul (100) nach Anspruch 1 oder 2,
wobei das LED-Modul (100) eine Abdeckung, insbesondere ein transluzentes Material zum Schutz des LED-Chips wie beispielsweise einen Globe-Top, umfasst, welche den zumindest einen Leuchtstoff (104) enthält.

4. LED-Modul (100) nach einem der vorstehenden Ansprüchen,
wobei der LED-Chip (102) die elektromagnetische Strahlung in einem violetten Wellenlängenbereich emittiert, welcher insbesondere keinen UV Anteil aufweist.

5. LED-Modul (100) nach einem der vorstehenden Ansprüchen,
wobei das Emissionsspektrum des LED-Moduls (100) in einem Bereich von 460 nm bis 550 nm, insbesondere in einem blauen Bereich, keine nach oben ausreißende Spitze zeigt.

6. LED-Modul (100) nach einem der vorstehenden Ansprüchen,
wobei das Emissionsspektrum des LED-Moduls (100) bei einer Farbtemperatur von 4000 K im Wesentlichen gleich einem normierten Tageslichtspektrum gemäß CIE einer höheren Farbtemperatur ist.

7. LED-Modul (100) nach Anspruch 6,
wobei die Farbtemperatur des normierten Tageslichtspektrums 5700 K ist.

8. LED-Modul (100) nach Anspruch 6 oder 7,
wobei das Emissionsspektrum des LED-Moduls (100) in einem azurblau bis grünen Bereich, beispielsweise von 460 nm bis 550 nm, bei einer Farbtemperatur von 4000 K bevorzugt nah an dem Tageslichtspektrum bei 5700 K liegt.

9. LED-Modul (100) nach einem der vorstehenden Ansprüchen 6 bis 8,
wobei eine Intensität des Emissionsspektrums unterhalb einer Intensität des Tageslichtspektrums bei identischer Temperatur beispielsweise 4000 K liegt.

10. LED-Modul (100) nach einem der vorstehenden Ansprüchen 1,
wobei ein Farbwiedergabeindex CRI des LED-Moduls (100) über 90 ist.

11. LED-Modul (100) nach einem der vorstehenden Ansprüchen,
wobei das Emissionsspektrum des LED-Moduls (100) durch eine farbstoffkonvertierte LED enthaltend den LED-Chip und den wenigstens einen Leuchtstoff (104) erzeugt wird oder wobei das Emissionsspektrum des LED-Moduls (100) durch Kombination einer farbstoffkonvertierte LED, enthaltend den LED-Chip (102) und den wenigstens einen Leuchtstoff, und optischen Eigenschaften einer Leuchte erzeugt wird.

12. LED-Modul (100) nach einem der vorstehenden Ansprüche,
wobei eine Intensität der elektromagnetischen Strahlung des LED-Chips (102) durch Amplituden- oder Pulsweiten-Modulation oder über einen Vorwärtsstrom veränderbar ist.

13. LED-Modul (100) nach einem der vorstehenden Ansprüche,
wobei in einem Bereich von 410 nm bis 430 nm eine erste Emissionsspitze des Emissionsspektrums des LED-Moduls liegt, welche eine geringere Intensität als eine zweite Emissionsspitze des Emissionsspektrums bei circa 460 nm hat.

14. LED-Modul (100) nach Anspruch 15,
wobei bei circa 605 nm eine dritte Emissionsspitze des Emissionsspektrums liegt, welche eine größere Intensität als die erste Emissionsspitze des Emissionsspektrums hat,
oder wobei bei circa 605 nm eine dritte Emissionsspitze des Emissionsspektrums liegt, welche eine geringere oder eine größere Intensität als die zweite Emissionsspitze des Emissionsspektrums hat.

15. Verfahren (700) für ein LED-Modul (100), umfassend:
- Emittieren (702) einer elektromagnetischen Strahlung mit einem LED-Chip (102);
- Umwandeln (704) der elektromagnetischen Strahlung des LED-Chips (102) in ein Licht, wobei ein Emissionsspektrum des LED-Modules (100) einen blauen Lichtanteil und einen grünen Lichtanteil enthält, wobei eine Intensität des blauen Lichtanteils größer als eine Intensität des vergleichbaren CRI (Farbwiedergabe) Referenzspektrum gemäß CIE Empfehlung bei gleicher Farbtemperatur ist und wobei eine Intensität des grünen Lichtanteils kleiner als eine CIE-Intensität gleicher Farbtemperatur ist.
